# EUROPEAN PATENT APPLICATION

(11) **EP 4 793 037 A1**
(43) Date of publication of application: **19.08.2026**
(21) Application number: 26157760.5
(22) Date of filing: 11.02.2026
(51) Int. Cl.: B32B 15/04, C01B 32/194

(54) **METHOD FOR PRODUCING STRUCTURE**

(30) Priority: 17.02.2025 FI 20255133
(71) Applicant: Canatu Finland Oy, 01720 Vantaa (FI)
(72) Inventor: Chiappe, Daniele, 01720 Vantaa (FI); Mikladal, Bjørn, 01720 Vantaa (FI); Soliman, Ahmed, 01720 Vantaa (FI); Mohl, Melinda, 01720 Vantaa (FI); Joensuu, Matilda, 01720 Vantaa (FI)
(74) Representative: Primrose Oy

(57) **Abstract**

The disclosure relates to a method for producing a structure (1) comprising a metal-containing layer (11) bonded to a first carbon allotrope layer (12). The method comprises providing a substrate (13), coating the substrate (13) with polymer to obtain a polymer layer (14), depositing metal-containing material on the polymer layer (14) to obtain a metal-containing layer (11), bonding a first carbon allotrope layer (12) to the metal-containing layer (11), and dissolving the polymer layer (14) using a solvent (2) for releasing the substrate (13) from the metal-containing layer (11).

## Description

### FIELD OF THE DISCLOSURE

The present disclosure relates to a structure comprising a carbon allotrope layer, and more particularly to a method for producing a structure comprising a metal-containing layer bonded to a first carbon allotrope layer.

### BACKGROUND OF THE DISCLOSURE

Optical filters are essential components in photonics and imaging technologies, designed to selectively transmit or block specific wavelengths of light. These filters play a critical role in applications such as spectroscopy, telecommunications, biomedical imaging, and photography. By manipulating the spectral composition of light, optical filters enhance system precision, optimize signal-to-noise ratios, and enable the isolation of desired optical properties.

Optical filters are typically categorized into types such as bandpass, long-pass, short-pass, and neutral density filters, each tailored for specific wavelength control. The material and coating technologies used-ranging from dielectric multilayers to metallic films-determine their performance, including spectral range, durability, and thermal resistance.

In imaging systems, optical filters improve accuracy and contrast by eliminating unwanted wavelengths, thereby reducing chromatic aberrations or glare. For instance, narrowband filters in fluorescence microscopy ensure the precise excitation and detection of specific fluorophores, enabling high-resolution imaging of biological samples. In telecommunications, optical filters ensure efficient wavelength multiplexing and demultiplexing, supporting high-bandwidth data transmission.

A metal layer combined with a carbon nanotube (CNT) film as a support for the metal layer can be used as an optical filter. A problem with obtaining such a filter is that the inherent surface roughness of a CNT film is too high, causing a reduced optical performance of the filter and scattering of the radiation passing through the filter, when the filter has been obtained by a direct deposition of the metal layer on the CNT film.

One solution to overcome this problem would be planarize the surface of the CNT film to reduce the surface roughness of the CNT film before deposition of the metal on the CNT film. However, a problem relating to planarizing the CNT film is that in a mass-production of filters each CNT film would need to be planarized separately, which is time-consuming and cost-intensive.

### BRIEF DESCRIPTION OF THE DISCLOSURE

An object of the present disclosure is to provide a method for producing a structure comprising a metal-containing layer bonded to a first carbon allotrope layer.

The object of the disclosure is achieved by the method which is characterized by what is stated in the independent claim. The preferred embodiments of the disclosure are disclosed in the dependent claims.

The disclosure is based on the idea of providing a method for producing a structure comprising a metal-containing layer bonded to a first carbon allotrope layer, wherein the method comprises
- providing a substrate having a planar surface,
- coating the planar surface of the substrate with polymer to obtain a polymer layer bonded to planar surface of the substrate,
- depositing metal-containing material on the polymer layer to obtain a metal-containing layer bonded to the polymer layer,
- providing a first carbon allotrope layer,
- bonding the first carbon allotrope layer to the metal-containing layer,
- after bonding a first carbon allotrope layer to the metal-containing layer, dissolving the polymer layer using a solvent for releasing the substrate from the metal-containing layer to obtain a structure comprising the metal-containing layer bonded to the first carbon allotrope layer.

An advantage of the disclosure is that the method allows providing a smooth metal-containing layer on the carbon allotrope layer despite the inherent surface roughness of the carbon allotrope layer.

Another advantage of the disclosure is that the smoothness of the surface of the metal-containing layer can be controlled by controlling the smoothness of the substrate. In other words, the method allows controlling the optical properties of the structure.

Still another advantage of the disclosure is that the substrate can be reused for the mass-production of the structures, reducing the costs involved in the production.

Still another advantage of the disclosure is that the resulting structure has a lower porosity than a structure obtained by depositing the metal-containing layer directly on the carbon allotrope layer.

Still another advantage of the disclosure is that, in the method, the manufacturing of the carbon allotrope material and the metal-containing layer is decoupled, allowing the optimization of each process separately.

### BRIEF DESCRIPTION OF THE DRAWINGS

The disclosure is described in detail with reference to the enclosed drawings, in which
Figure 1 illustrates a schematic cross-sectional view of the structure during different steps (1-1 to 1-7) of the method according to some embodiments;
Figure 2 illustrates a schematic cross-sectional view of the structure during different steps (2-1 to 2-7) of the method according to some embodiments; and
Figures 3a and 3b illustrate a schematic cross-sectional view of the structure during different steps (3-1 to 3-9) of the method according to some embodiments.

### DETAILED DESCRIPTION OF THE DISCLOSURE

The disclosure relates to a method for producing a structure 1 comprising a metal-containing layer 11 bonded to a first carbon allotrope layer 12. For example, the structure 1 may be used as an optical filter for blocking other wavelengths of the electromagnetic radiation, such as visible light.

### Providing substrate

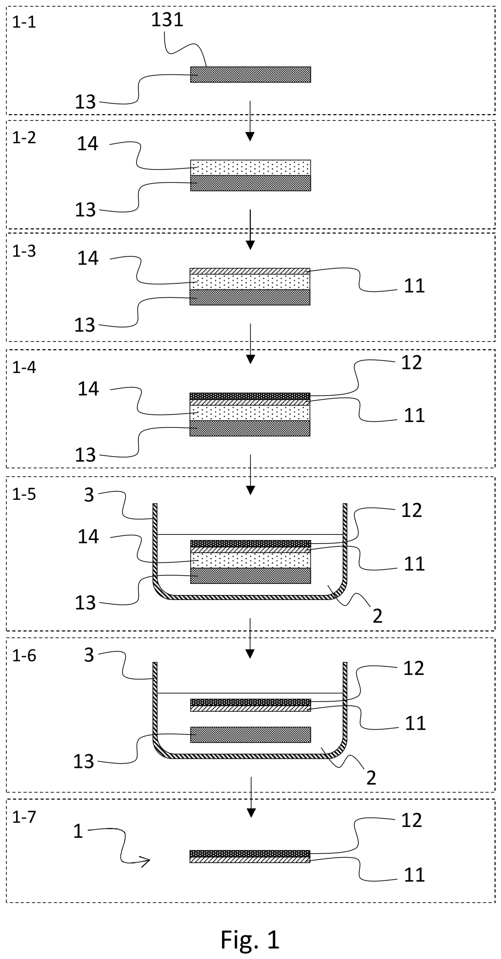

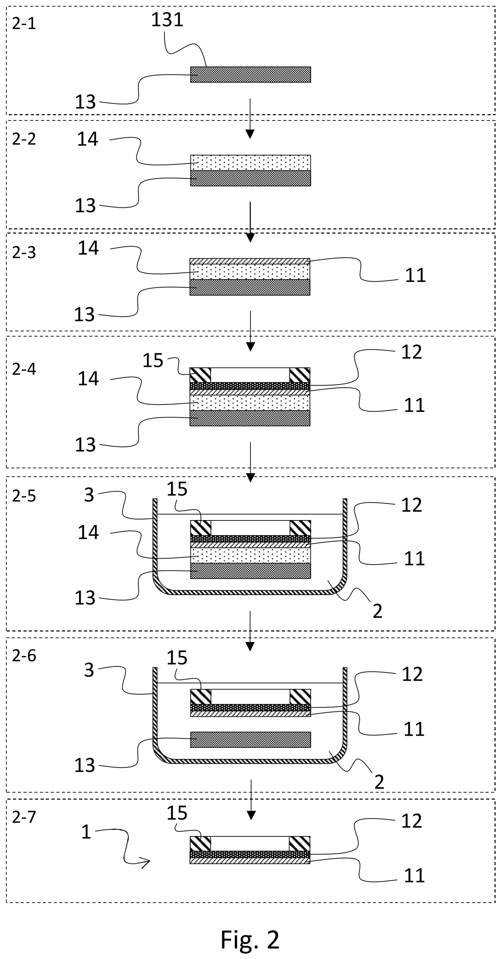

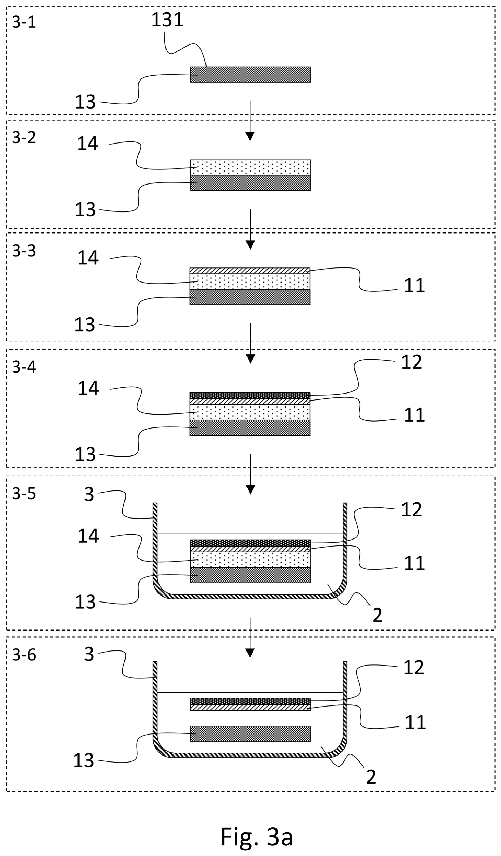

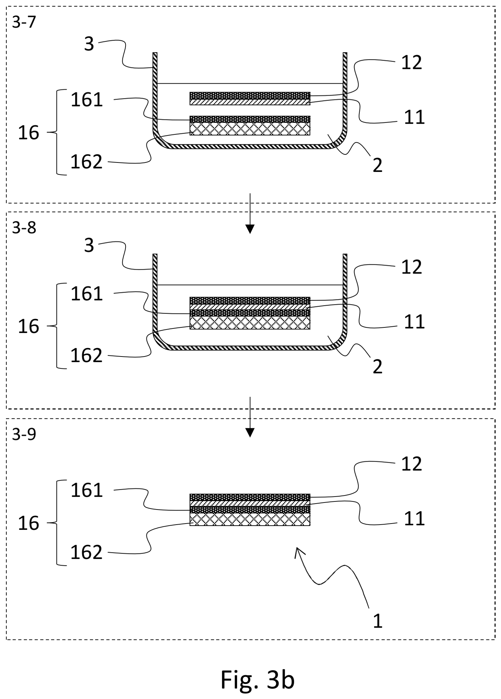

The method comprises providing a substrate 13 having a planar surface 131, as exemplified in Figure 1, step 1-1, Figure 2, step 2-1, and Figure 3, step 3-1. In other words, at least one surface of the substrate 13 has a planar shape. For example, the substrate 13 is silicon, such as silicon wafer, quartz, glass, sapphire, polymer, such as polyethylene terephthalate (PET), poly(methyl methacrylate) (PMMA), polycarbonate (PC) or polyimide (PI), silicon dioxide (SiO₂), metal, such as gold, silver, aluminium or copper, or dielectric coated substrate, such as TiO₂, Al₂O₂, ZnO or HfO₂, mica or polymethylsiloxane (PDMS).

The planar surface 131 has a low surface roughness. According to some embodiments, the planar surface 131 of the substrate 13 has a surface roughness of at most 20 nm, preferably at most 5 nm, such as 0.01 to 1 nm, wherein the surface roughness is determined as the arithmetic average value of a filtered roughness profile determined from deviations about a centre line within the evaluation length.

### Coating substrate with polymer

The method comprises coating the planar surface 131 of the substrate 13 with polymer to obtain a polymer layer 14 bonded to the planar surface 131 of the substrate 13, as exemplified in Figure 1, step 1-2, Figure 2, step 2-2, and Figure 3, step 3-2. Preferably, the polymer layer 14 has a uniform thickness. Due to the low surface roughness of the planar surface 131 of the substrate 13, the polymer layer 14 also has a low surface roughness. This is because the surface structure of the planar surface 131 is replicated by the polymer layer 14. The purpose of the polymer layer 14 is to act as a smooth, removable base for forming a metal-containing layer 11.

Preferably, the polymer is a polymer that is easily dissolvable. Preferably, the polymer is compatible with dip-coating or spin-coating application, or with vapour phase deposition. According to some embodiments, the polymer is selected from a group consisting of polymethyl methacrylate (PMMA), polyvinyl alcohol (PVA), cyclo-olefin polymer (COP), cyclo-olefin copolymer (COC), polydimethylsiloxane (PDMS), polycarbonate (PC), polyethylene terephthalate (PET), polystyrene (PS), fluoropolymers, polyether ether ketone (PEEK), polyimide (PI), polyethylene glycol (PEG), polyvinylidene fluoride (PVDF), poly(3-hexylthiophene) (P3HT), poly(ethylene oxide) (PEO), poly(lactic acid) (PLA), poly(4-vinylphenol) (PVP) and SU-8.

According to some embodiments, the planar surface 131 of the substrate 13 is coated with the polymer using dip-coating or spin-coating. This is to obtain a uniform thickness of the polymer layer 14. In dip-coating, the substrate 13 is dipped in liquid polymer and allowed to cure. In spin coating, liquid polymer is applied on the planar surface 131 of the substrate 13, the substrate 13 is rotated about an axis that is normal to the planar surface 131, causing the polymer to spread evenly on the planar surface 131, and allowed to cure.

Preferably, the polymer is amorphous. In other words, the polymer has a low degree of crystallinity. Low degree of crystallinity makes the polymer easier to dissolve by a solvent than a polymer with a high degree of crystallinity.

Preferably, the thickness of the polymer layer 14 is 0.1 to 5 µm, such as 0.5 to 2 µm.

### Depositing metal-containing material

The method comprises depositing metal-containing material on the polymer layer 14 to obtain a metal-containing layer 11 bonded to the polymer layer 14, as exemplified in Figure 1, step 1-3, Figure 2, step 2-3, and Figure 3, step 3-3. In other words, the metal-containing layer 11 is deposited on the polymer layer 14 on a surface opposite the surface bonded to the substrate 13. The purpose of the metal-containing layer 11 is to act as a functional layer of the structure. For example, the metal-containing layer 11 acts as the filter element in the optical filter mentioned above.

As a result of depositing the metal-containing material on the polymer layer 14, a layered structure of the metal-containing layer 11, the polymer layer 14 and the substrate 13, in this order, is obtained.

According to some embodiments, the metal-containing material is a metal selected from a group consisting of molybdenum (Mo), niobium (Nb), zirconium (Zr), aluminium (Al), silver (Ag), gold (Au), copper (Cu), titanium (Ti), nickel (Ni) and chromium (Cr), or the metal-containing material is a silicide selected from a group consisting of molybdenum silicide, niobium silicide, zirconium silicide aluminium silicide, silver silicide, gold silicide, copper silicide, titanium silicide, nickel silicide, cobalt silicide, platinum silicide, tungsten silicide and chromium silicide, or the metal-containing material is selected from a group consisting of indium tin oxide (ITO), aluminium-doped zinc oxide (AZO), fluorine-doped tin oxide (FTO), titanium dioxide (TiO₂), zinc oxide (ZnO), titanium nitride (TiN), tantalum nitrode (TaN), magnesium fluoride (MgF₂), calcium fluoride (CaF₂), lithium fluoride (LiF), zinc sulfide (ZnS), zinc selenide (ZnSe), cadmium sulfide (CdS) and lead sulfide (PbS).

According to some embodiments, the metal-containing material is deposited by physical vapour deposition (PVD), such as by electron beam physical vapour deposition (EBPVD) or thermal evaporation, by atomic layer deposition (ALD), by electrodeposition, or by dip or spin coating.

The thickness of the metal-containing layer 11 depends on the desired properties of the metal-containing layer 11. Preferably, the thickness of the metal-containing layer 11 is 10 to 50 nm.

### Providing first carbon allotrope layer

The method comprises providing a first carbon allotrope layer 12. The first carbon allotrope layer 12 is a film comprising at least one allotrope of carbon. The purpose of the first carbon allotrope layer 12 is to provide mechanical stability to the structure 1.

Preferably, the first carbon allotrope layer 12 is a layer comprising carbon allotropes selected from carbon nanotubes and graphene.

A carbon nanotube (CNT) is a tube made of carbon with a diameter in the nanometre range. In the context of this disclosure, term *"carbon nanotubes"* covers both single-walled carbon nanotubes (SWCNTs) and multi-walled carbon nanotubes (MWCNTs). Graphene is a carbon allotrope consisting of a single layer of atoms arranged in a honeycomb planar nanostructure.

Preferably, the first carbon allotrope layer 12 comprises carbon allotropes at least 50 % by weight, preferably at least 75 % by weight, more preferably at least 90 % by weight, most preferably at least 99 % by weight. For example, the first carbon allotrope layer 12 consists of carbon allotropes.

Document WO 2023/209271 A1 discloses a method for producing a carbon allotrope film usable as the first carbon allotrope layer 12.

According to some embodiments, the first carbon allotrope layer 12 is bonded to a frame 15 for supporting the first carbon allotrope layer 12, as exemplified in Figure 2. In other words, the first carbon allotrope layer 12 is provided as bonded to the frame 15. The purpose of the frame 15 is to provide support for the first carbon allotrope layer 12. For example, the frame 15 is an annular metal frame 15.

According to some embodiments, providing the first carbon allotrope layer 12 comprises bonding the first carbon allotrope layer 12 to the frame 15.

### Bonding first carbon allotrope layer

The method comprises bonding the first carbon allotrope layer 12 to the metal-containing layer 11, as exemplified in Figure 1, step 1-4, Figure 2, step 2-4, and Figure 3, step 3-4. For example, bonding the first carbon allotrope layer 12 to the metal-containing layer 11 is conducted by bringing the first carbon allotrope layer 12 in contact with the metal-containing layer 11. Preferably, the first carbon allotrope layer 12 is brought in contact with the metal-containing layer 11 in an environment containing liquid medium, for example isopropyl alcohol (IPA) or acetone. The purpose of the liquid medium is to facilitate the bonding of the first carbon allotrope layer 12 to the metal-containing layer 11.

Preferably, if the first carbon allotrope layer 12 is bonded to the frame 15, the surface of the first carbon allotrope layer 12 opposite the surface bonded to the frame 15 is bonded to the metal-containing layer 11. As a result, the metal-containing layer 11 and the frame 15 are connected to opposite surfaces of the first carbon allotrope layer 12.

As a result of bonding the first carbon allotrope layer 12 to the metal-containing layer 11, a layered structure of the optional frame 15, the first carbon allotrope layer 12, the metal-containing layer 11, the polymer layer 14 and the substrate 13, in this order, is obtained.

### Pre-bonding treatment

According to some embodiments, the method comprises, before bonding the first carbon allotrope layer 12 on the metal-containing layer 11, conducting a pre-treatment to the metal-containing layer 11 to improve the adhesion of the first carbon allotrope layer 12 to the metal-containing layer 11. The purpose of the pre-treatment is to control the surface termination and hydrophobicity of the metal-containing layer 11.

For example, the pre-treatment is a plasma treatment, a thermal treatment, a chemical treatment, such as an acid treatment or a thiol treatment.

### Dissolving polymer layer

The method comprises, after bonding a first carbon allotrope layer 12 to the metal-containing layer 11, dissolving the polymer layer 14 using a solvent 2, as exemplified in Figure 1, steps 1-5 and 1-6, Figure 2, steps 2-5 and 2-6, and Figure 3, steps 3-5 and 3-6. As a result, the substrate 13 is released from the metal-containing layer 11 and a structure 1 comprising the metal-containing layer 11 bonded to the first carbon allotrope layer 12 is obtained, as exemplified in Figure 1, step 1-7, and Figure 2, step 2-7.

The solvent 2 comprises a solvent component capable of dissolving the polymer. In other words, the solvent 2 depends on the polymer used. The solvent 2 may comprise a single solvent component or a mixture of solvent components. For example, the solvent component is selected from a group consisting of water, acetone, chloroform, toluene, dichloromethane (DCM), ethyl acetate, cyclohexane, xylene, phenol, dichlorobenzene, trifluoroacetic acid, dimethylacetamide (DMAc), n-methyl-2-pyrrolidone (NMP), dimethylformamide (DMF), hexane, tetrahydrofuran, water, ethanol, methanol, propylene glycol methyl ether acetate (PGMEA), and perfluorotributylamine.

According to some embodiments, dissolving the polymer layer 14 comprises heating the solvent 2 to increase dissolving of the polymer. For example, the solvent 2 is heated to a temperature of 40 to 80 °C.

For example, dissolving the polymer layer 14 is conducted by placing the layered structure of the optional frame 15, the first carbon allotrope layer 12, the metal-containing layer 11, the polymer layer 14 and the substrate 13 in a vessel 3 containing the solvent 2 in such a way that the layered structure is at least partially submerged in the solvent 2, and allowing the solvent 2 to dissolve the polymer layer 14, as exemplified in Figure 2, steps 2-5 and 2-6.

### Encapsulating metal-containing layer

According to some embodiments, the method comprises providing a laminate 16 comprising a second carbon allotrope layer 161 bonded to a metal mesh 162, as exemplified in Figure 3, step 3-7.

The second carbon allotrope layer 161 is a layer comprising at least one allotrope of carbon. The purpose of the second carbon allotrope layer 161 is to allow encapsulating the metal-containing layer 11 between the first carbon allotrope layer 12 and the second carbon allotrope layer 161.

Preferably, the second carbon allotrope layer 161 is a layer comprising carbon allotropes selected from carbon nanotubes and graphene.

Preferably, the second carbon allotrope layer 161 comprises carbon allotropes at least 50 % by weight, preferably at least 75 % by weight, more preferably at least 90 % by weight, most preferably at least 99 % by weight. For example, the second carbon allotrope layer 161 consists of carbon allotropes.

For example, the metal mesh 162 is made of stainless steel, Si₃N₄, molybdenum, carbon nanotubes, SiO₂, indium tin oxide (ITO), poly(methyl methacrylate), or polyethylene terephthalate (PET).

For example, the metal mesh 162 is made of stainless steel having a thickness of 50 µm.

For example, the metal mesh 162 has a hexagonal pattern where each hexagon has a width of approximately 1 to 2 mm.

In these embodiments, after dissolving the polymer layer 14, the method comprises bonding the second carbon allotrope layer 161 to the metal-containing layer 11, as exemplified in Figure 3, step 3-8. In other words, a surface of the second carbon allotrope layer 161 opposite the surface bonded to the metal mesh 162 is bonded to the metal-containing layer 11. In still other words, the second carbon allotrope layer 161 is bonded to a surface of the metal-containing layer 11 opposite the surface bonded to the first carbon allotrope layer 12. For example, the second carbon allotrope layer 161 is bonded to the metal-containing layer 11 by bringing the second carbon allotrope layer 161 in contact with the metal-containing layer 11. Preferably, the second carbon allotrope layer 161 is brought in contact with the metal-containing layer 11 in an environment containing liquid medium, for example isopropyl alcohol (IPA) or acetone. The purpose of the liquid medium is to facilitate the bonding of the second carbon allotrope layer 161 to the metal-containing layer 11.

As a result, a structure 1 comprising the first carbon allotrope layer 12, the metal-containing layer 11, the second carbon allotrope layer 161 and the metal mesh 162, in this order, is obtained, as exemplified in Figure 3, step 3-9. In other words, a structure 1 comprising the metal-containing layer 11 sandwiched or encapsulated between the first carbon allotrope layer 12 and the second carbon allotrope layer 161 on the metal mesh 162 is obtained.

For example, the laminate 16 comprising the second carbon allotrope layer 161 bonded to the metal mesh 162 is provided in the vessel 3 containing the solvent 2, and bonding the second carbon allotrope layer 161 to the metal-containing layer 11 is conducted by bringing the second carbon allotrope layer 161 in contact with the metal-containing layer 11 in the vessel 3.

### EXAMPLES

### Example 1

A silicon wafer substrate was coated with polymethyl methacrylate (PMMA) by dipping the silicon wafer in PMMA (2 %, mol weight) dissolved in methyl isobutyl ketone (MIBK) and acetic acid (MIBK : acetic acid = 3:1) with dip in/out speed of 25/25 mm/min. The coated substrate was baked in a ventilated oven at 100 °C for 15 minutes.

A gold-palladium layer having a thickness of 30 nm was deposited on the coated substrate using physical vapour deposition (PVD) (Quorum, Aalto univ. SEM lab).

A carbon nanotube film bonded to an annular metal frame with a hole in the middle was bonded to the palladium layer by dipping the carbon nanotube film into isopropyl alcohol (IPA) at room temperature, transferring the carbon nanotube film onto the palladium layer and allowing to dry.

The PMMA layer was dissolved by placing the layered structure in a vessel containing acetone at room temperature until the substrate was released from the rest of the layered structure.

As a result, a structure containing a gold-palladium layer on the carbon nanotube film was obtained.

### Example 2

A silicon wafer substrate was coated with polymethyl methacrylate (PMMA) by dipping the silicon wafer in PMMA (2 %, mol weight) dissolved in methyl isobutyl ketone (MIBK) and acetic acid (MIBK : acetic acid = 3:1) with dip in/out speed of 25/25 mm/min. The coated substrate was baked in a ventilated oven at 100 °C for 15 minutes.

A molybdenum layer having a thickness of 30 nm was deposited on the coated substrate using physical vapour deposition (PVD) (Angstrom, Aalto univ., Thin Film Lab).

The molybdenum layer was treated with H₂ plasma having a power of 40 W and a flow rate of 20 SCCM for 3 minutes.

A first carbon nanotube film was bonded to the molybdenum layer by dipping the first carbon nanotube film into isopropyl alcohol (IPA) at room temperature, transferring the carbon nanotube film onto the molybdenum layer and allowing to dry.

The PMMA layer was dissolved by placing the layered structure in a vessel containing acetone at a standard room temperature until the substrate was released from the rest of the layered structure, resulting in the layered structure floating on the surface of the acetone solution. A few droplets of IPA were added to acetone to reduce the surface tension of the acetone solution and to facilitate the floating of the layered structure.

A second carbon nanotube film bonded to a metal mesh was immersed into the acetone solution at an angle to minimize the formation of air bubbles. The second carbon nanotube film was brought in contact with the molybdenum layer of the rest of the layered structure by slowly lifting the second carbon nanotube film bonded to the metal mesh out of the acetone solution to adhere the floating layered structure to the surface of the second carbon nanotube film and to obtain the final structure. The final structure was removed from the vessel and heated to 80 °C on a hot plate to bond the second carbon nanotube film to the molybdenum layer.

As a result, a structure containing a molybdenum layer sandwiched between two carbon nanotube films on a metal mesh was obtained.

## Claims

1. A method for producing a structure (1) comprising a metal-containing layer (11) bonded to a first carbon allotrope layer (12), **characterized in that** the method comprises
- providing a substrate (13) having a planar surface (131),
- coating the planar surface (131) of the substrate (13) with polymer to obtain a polymer layer (14) bonded to planar surface (131) of the substrate (13),
- depositing metal-containing material on the polymer layer (14) to obtain a metal-containing layer (11) bonded to the polymer layer (14),
- providing a first carbon allotrope layer (12),
- bonding the first carbon allotrope layer (12) to the metal-containing layer (11), and
- after bonding a first carbon allotrope layer (12) to the metal-containing layer (11), dissolving the polymer layer (14) using a solvent (2) for releasing the substrate (13) from the metal-containing layer (11) to obtain a structure (1) comprising the metal-containing layer (11) bonded to the first carbon allotrope layer (12).

2. The method according to claim 1, **characterized in that** the first carbon allotrope layer (12) is a layer comprising carbon allotropes selected from carbon nanotubes and graphene.

3. The method according to claim 1 or 2, **characterized in that** the planar surface (131) of the substrate (13) has a surface roughness of at most 20 nm, preferably at most 5 nm, such as 0.01 to 1 nm, wherein the surface roughness is determined as the arithmetic average value of a filtered roughness profile determined from deviations about a centre line within the evaluation length.

4. The method according to any one of the preceding claims, **characterized in that** the polymer is selected from a groups consisting of poly(methyl methacrylate) (PMMA), polyvinyl alcohol (PVA), cyclo-olefin polymer (COP), cyclo-olefin copolymer (COC), polydimethylsiloxane (PDMS), polycarbonate (PC), polyethylene terephthalate (PET), polystyrene (PS), fluoropolymers, polyether ether ketone (PEEK), polyimide (PI) and SU-8.

5. The method according to any one of the preceding claims, **characterized in that** the planar surface (131) of the substrate (13) is coated with the polymer using dip-coating or spin-coating.

6. The method according to any one of the preceding claims, **characterized in that** the metal-containing material is a metal selected from a group consisting of molybdenum (Mo), niobium (Nb), zirconium (Zr), aluminium (Al), silver (Ag), gold (Au), copper (Cu), titanium (Ti), nickel (Ni) and chromium (Cr), or the metal-containing material is a silicide selected from a group consisting of molybdenum silicide, niobium silicide, zirconium silicide, aluminium silicide, silver silicide, gold silicide, copper silicide, titanium silicide, nickel silicide and chromium silicide, or the metal-containing material is selected from a group consisting of indium tin oxide (ITO), aluminium-doped zinc oxide (AZO), fluorine-doped tin oxide (FTO), titanium dioxide (TiO₂), zinc oxide (ZnO), titanium nitride (TiN), tantalum nitrode (TaN), magnesium fluoride (MgF₂), calcium fluoride (CaF₂), lithium fluoride (LiF), zinc sulfide (ZnS), zinc selenide (ZnSe), cadmium sulfide (CdS) and lead sulfide (PbS).

7. The method according to any one of the preceding claims, **characterized in that** the metal-containing material is deposited by physical vapour deposition (PVD), such as by electron beam physical vapour deposition (EBPVD) or thermal evaporation, by atomic layer deposition (ALD), by electrodeposition, or by dip or spin coating.

8. The method according to any one of the preceding claims, **characterized in that** the method comprises, before bonding the first carbon allotrope layer (12) on the metal-containing layer (11), conducting a pre-treatment to the metal-containing layer (11), wherein the pre-treatment is selected from a plasma treatment, thermal treatment and a chemical treatment.

9. The method according to any one of the preceding claims, **characterized in that** the first carbon allotrope layer (12) has been bonded to a frame (15) for supporting the first carbon allotrope layer (12).

10. The method according to any one of the preceding claims, **characterized in that** the method comprises
- providing a laminate (16) comprising a second carbon allotrope layer (161) bonded to a metal mesh (162), and
- after dissolving the polymer layer (14), bonding the second carbon allotrope layer (161) to the metal-containing layer (11) to obtain a structure (1) comprising the first carbon allotrope layer (12), the metal-containing layer (11), the second carbon allotrope layer (161) and the metal mesh (162).
